# EUROPÄISCHE PATENTSCHRIFT

(11) **EP 1 109 320 B1**
(45) Veröffentlichungstag und Bekanntmachung des Hinweises auf die Patenterteilung: **06.04.2005**
(21) Anmeldenummer: 00127018.0
(22) Anmeldetag: 09.12.2000
(51) Int. Cl.: H03M 13/15, H04L 1/00

(54) **Einrichtung zur Datenumsetzung für einen Reed-Solomon Dekodierer**
Device for converting data for a Reed-Solomon decoder
Dispositif pour convertir les données d'un décodeur Reed-Solomon

(30) Priorität: 17.12.1999 DE 19960923
(43) Veröffentlichungstag der Anmeldung: 20.06.2001
(73) Patentinhaber: Micronas GmbH, 79108 Freiburg (DE)
(72) Erfinder: Witte, Franz-Otto, Dr. Ing., 79312 Emmendingen (DE); Zens, Volker, Dipl.-Ing., 79211 Denzlingen (DE)
(74) Vertreter: Sauer, Wolfgang, Dipl.-Ing.

(56) Entgegenhaltungen:
- EP-A- 1 035 662
- US-A- 3 745 528
- US-A- 4 796 110
- US-A- 4 896 353
- US-A- 5 377 207

## Beschreibung

Die Erfindung betrifft eine Einrichtung für einen Reed-Solomon Dekodierer, der im Zeitmultiplexbetrieb aus einer Datenquelle mit einem ersten und zweiten Datenstrom, deren Daten jeweils einem ersten und zweiten Reed-Solomon Code entsprechen, gespeist ist. Derartige Datenströme werden zunehmend bei der digitalen Übertragung von Signalen aus dem Audio- oder Videobereich verwendet. Neben der Codierung des eigentlichen Signalinhalts, der im zeitlichen Multiplexbetrieb mit anderen Signalen übertragen wird, sind auch Informationen zu übertragen, die zum Auffinden und Dekodieren des gewünschten Signals innerhalb des empfangenen Datenstroms dienen. Die im Zeitmultiplexbetrieb aneinandergefügten Signaldaten werden auf der Senderseite blockweise zur Datensicherung nach der ersten und die Steuerinformationen nach dem zweiten Reed-Solomon Code umgesetzt und bilden somit den ersten und zweiten Datenstrom. Die Übertragung dieser beiden Datenströme erfolgt seriell im Zeitmultiplexbetrieb. Das Format, in dem diese Datenströme übertragen werden, enthält in einem Kopfteil den zweiten Datenstrom mit den Kanal- und Steuerinformationen und in einem nachfolgenden Datenblock den ersten Datenstrom mit den Signalinhalten. Der erste Datenstrom wird in einigen Anwendungen als "Broadcast Channel" (=BC) und der zweite Datenstrom als "Time Slot Control Channel" (=TSCC) bezeichnet, in der folgenden Beschreibung wird dies spezielle Bezeichnung jedoch nicht weiter verwendet. Durch die vorgegebene Anordung können die beiden Datenströme auf der Empfängerseite wieder leicht getrennt werden. Die nachfolgende Verarbeitung erfolgt mit unterschiedlicher Geschwindigkeit, je nachdem ob der erste oder zweite Datenstrom zu verarbeiten ist. Im zweiten Datenstrom sind alle aufeinanderfolgenden Daten wichtig und müssen daher alle erfaßt und verarbeitet werden. Im ersten Datenstrom, der zwar die gleiche Datenrate wie der zweite Datenstrom aufweist, müssen nicht alle aufeinanderfolgenden Daten oder Datenworte erfaßt und verarbeitet werden, sondern nur diejenigen, die für den zu empfangenden Kanal relevant sind. Bei einer Vielzahl von Kanälen, die im zeitlichen Multiplexbtrieb übertragen werden, folgen auf ein relevantes Datenwort eine Vielzahl von nicht zu beachtende Datenworte. Dadurch reduziert sich die erforderliche Verarbeitungsgeschwindigkeit im entsprechenden Verhältnis.

Unterschiedliche Codierungen nach dem Reed-SolomonVerfahren unterscheiden sich in der Regel dadurch, daß die zugehörigen endlichen Körper, die auch als Galois-Körper (angelsächsisch: Galois-Field) bezeichnet werden, durch unterschiedliche primitive Polynome und die unterschiedlichen Parameter der codegenerierenden Polynome definiert sind. Die grundsätzliche Codierung und die Dekodierung derartiger Reed-Solomon Codes ist nicht Gegenstand der Erfindung. Beides ist bekannt und in einschlägigen Fachbüchern ausführlich beschrieben, vergleiche beispielsweise: Richard E. Blahut, "Theory and Practice of Error Control Codes", 1983 bei Addison-Wesley Publishing Company, Inc., ca. 500 Seiten, ISBN 0-201-10102-5 oder Martin Bossert, "Kanalcodierung", 1992 bei B. G. Teubner Stuttgart, ca. 283 Seiten, ISBN 3-519-06143-0. Eine weitere Sicherung gegenüber Übertragungsfehlern kann mit zusätzlichen Codierungsverfahren erreicht werden, beispielsweise einer vorwärtsgerichteten Fehlerkorrektur nach Viterbi.

Die nach dem Prioritätstag dieser Anmeldung veröffentlichte europäische Anmeldung EP-A-1035662 zeigt die Dekodierung von Daten, welche durch zwei unterschiedliche lineare Codes codiert wurde.

Zur Verarbeitung von zwei Datenströmen, denen unterschiedliche Reed-Solomon Codes zugrunde gelegt sind, sind zwei voneinander unabhängige Reed-Solomon Dekodierer erforderlich. Und entsprechend ist für jeden weiteren Datenstrom ebenfalls ein weiterer Reed-Solomon Dekodierer erforderlich. Wegen der hohen Datenrate der zu verarbeitenden Daten im Echtzeitbetrieb sind wesentliche Teile der beiden Reed-Solomon Dekodierer als Hardware-Schaltung in einem speziell ausgebildeten GK-Prozessor ("GK" steht für Galois-Körper, im angelsächsischen Sprachbereich folgt daraus die Bezeichnung "Galois-Field Processor" oder "GF-Processor") zu realisieren, weil ein entsprechendes Unterprogramm in üblichen Universalprozessoren nicht schnell genug ist. Einer dieser zentralen Funktionsblöcke ist ein Multiplizierer, mit dem zwei Polynome parallel miteinander multipliziert werden. Die gewünschte Signalauflösung bestimmt dabei die Wortbreite und diese die Ordnung des zugehörigen Galois-Körpers. Ab einem Galois-Körper 7. Ordnung wird der Aufwand für derartige Parallelmulitplizierer sehr groß, denn es sind gleichzeitig 7 x 7 logische Operationen entsprechend der Wortbreite von 7 Bit durchzuführen. Es handelt sich dabei um einen speziellen Multiplizierer, der in der Art einer Modulo-Operation als resultierende Elemente der Multiplikation immer wieder nur Elemente des endlichen Körpers bildet. Das Array dieser Multiplizierer vereinfacht sich dadurch gegenüber dem Array eines normalen Parallelmultiplizierers. Die logischen Verknüpfungen der einzelnen Partialprodukte bei dieser Modulo-Operation entsprechen der "Exklusiv-Oder"-Verknüpfung (=XOR) und der logischen "Und"-Verknüpfung (=AND). Trotz dieser Vereinfachung stellt der Modulo-Multiplizierer einen erheblichen Aufwand innerhalb des GK-Prozessors dar.

Es ist daher Aufgabe der Erfindung einen vereinfachten GK-Prozessor anzugegeben, mit dem mindestens zwei mit unterschiedlichen Reed-Solomon Codes umgesetzte Datenströme in Echtzeit dekodiert werden können.

Die Lösung der Aufgabe erfolgt nach dem Merkmalen des Anspruchs 1. Der Grundgedanke der Erfindung besteht darin, für die Reed-Solomon Dekodierung des einen Datenstromes die isomorphen Abbildungseigenschaften von Galois-Köpem gleicher Ordnung auszunutzen. Dies ist dann möglich, wenn die beiden Körper durch unterschiedliche primitive Polynome gleichen Grades definiert sind. Durch diese Transformation ist nur ein einziger Reed-Solomon Dekodierer für beide Datenströme erforderlich, wobei im einzigen GK-Prozessor dann die unterschiedlichen Parameter für die jeweiligen Generator-Polynome von einer Steuereinrichtung eingestellt werden müssen. Selbstverständlich können auch weitere Datenströme auf gleiche Weise isomorph abgebildet und danach dekodiert werden sofern deren Galois-Körper die gleiche Ordnung wie die beiden ersten Galois-Körper aufweisen.

Die Erfindung und vorteilhafte Ausgestaltungen werden nun anhand der Figuren der Zeichnung näher erläutert:
Fig. 1 zeigt die Erfindung schematisch als Blockschaltbild mit typischem Umfeld,
Fig. 2 zeigt die Herleitung der Elemente eines ersten primitiven Polynoms,
Fig. 3 zeigt die Herleitung der Elemente eines zweiten primitiven Polynoms und
Fig. 4 zeigt in Tabellenform die Suche nach Lösungen für die isomorphen Abbildung.

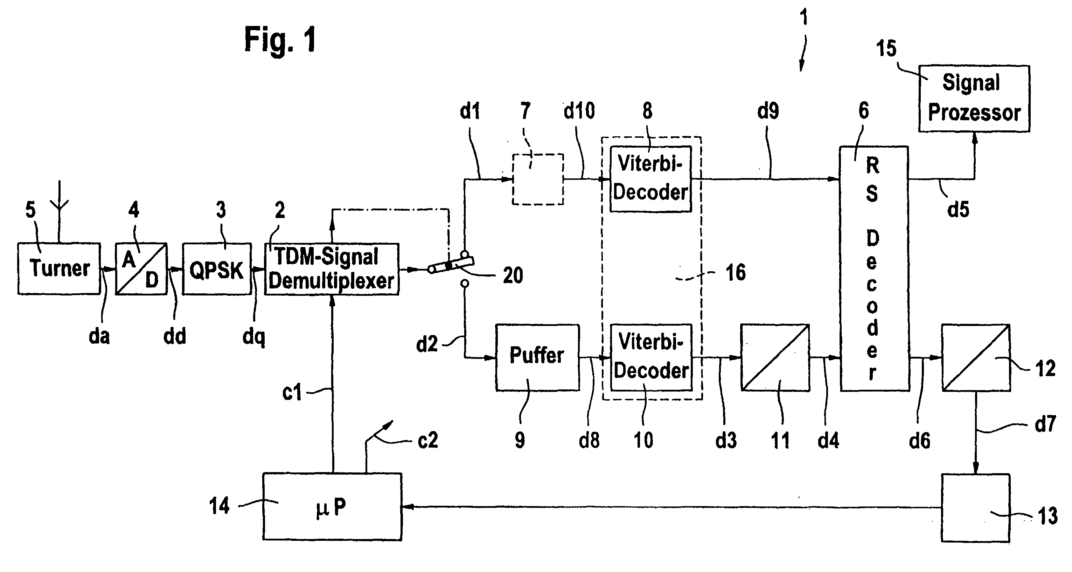

Fig. 1 zeigt schematisch als Blockschaltbild eine Einrichtung 1 für einen Reed-Solomon Dekodierer innerhalb eines GK-Prozessors, der zwei unterschiedliche, Reed-Solomon kodierte Datenströme d1, d2 dekodiert. Die Quelle 2 für die beiden Datenströme d1, d2 ist beispielsweise ein TDM-Signal-Demultiplexer (TDM = Time Division Multiplex), der die beiden Datenströme aus einem Datenstrom dq herausfiltert, der mit einem vorgegebenen Datenformat von einem QPSK-Demodulator 3 (QPSK = Quadrature Phase Shift Keying) geliefert wird. Die Herausfilterung des ersten und zweiten Datenstromes d1, d2 aus dem Datenstrom dq ist in der Anordnung von Fig. 1 mittels eines elektronischen Umschalters 20 angedeutet, dessen Steuereingang vom TDM-Signal-Demultiplexer 2 in Abhängigkeit von der Kopfinformation des Datenstroms dq geschaltet ist. Zudem sucht der TDM-Signal-Demultiplexer 2 aus der kanalweise übertragenen Information im Datenbereich des Datenstroms dq für den ersten Datenstrom d1 nur diejenigen Daten aus, die dem gewünschten Kanal zugeordnet sind. Der QPSK-Demodulator 3 bestimmt, in welchem der vier möglichen Quadranten der Phasenwert des empfangenen Signals dd liegt. Aus der Quadrantenzuordnung werden dann die zugehörigen Symbole bestimmt, deren Daten in Form eines kontinuierlichen Datenstroms dq das digitale TDM-Signal enthalten. Der QPSK-Demodulator 3 und die nachfolgenden Stufen verarbeiten im Ausführungsbeispiel von Fig. 1 digitalisierte Signale. Die Digitalisierung erfolgt in einem Analog-Digital-Umsetzer 4, der von einem analogen Ausgangssignal da eines Tuners 5 gespeist ist und als Ausgangssignal ein digitalisiertes Signal dd liefert, dessen Taktrate mindestens doppelt so hoch wie die Symbolrate ist. Beispielsweise ist für eine Symbolrate von 4 MHz eine Taktrate von mindestens 8 MHz erforderlich und die Auflösung sollte mindestens 32 Stufen, also 5 Bit umfassen.

Die Schaltungsblöcke des GK-Prozessors enthalten für den ersten und zweiten Datenstrom d1, d2 als wesentliche Einheit einen Reed-Solomon Dekodierer 6. Im Signalfluß davor liegt für den ersten Datenstrom d1 eine Zwischenverarbeitungsstufe 7, 8. Für den zweiten Datenstrom d2 liegt vor dem Reed-Solomon Dekodierer 6 eine Zwischenverarbeitungsstufe 9, 10 und ein erster Codeumsetzer 11, der den Datenstrom d3 an seinem Eingang isomorph in einen Datenstrom d4 umsetzt, mit dem dann der Reed-Solomon Dekodierer 6 gespeist ist. Der isomorphen Abbildung vor dem Reed-Solomon Dekodierer 6 entspricht eine inverse, ebenfalls isomorphe Abbildung des Datenstromes d6 in einem Codeumsetzer 12 nach dem Reed-Solomon Dekodierer, mit der die isomorphe Abbildung wieder rückgängig gemacht wird, nachdem die Reed-Solomon Dekodierung stattgefunden hat. Der zugehörige Datenstrom d7 wird in einem statischen Speicher 13 gespeichert. Dieser ist vorzugsweise ein Teil einer Steuereinrichtung 14, die in Abhängigkeit von diesen Daten Steuerbefehle c1, c2 für die Gesamtanordnung erzeugt und auch die jeweiligen Parameter dr Generatorpolynome im Reed-Solomon Dekodierer vorgibt. Die Steuereinrichtung 14 ist vorzugsweise ein mitintegrierter Mikro-Controller (=µC), damit die vom ersten Datenstrom d1 abhängigen Steuerbefehle c1, c2 möglichst ohne Verzögerung zur Verfügung stehen. Dies ist besonders wichtig für die Einstellung der Selektionsparameter im TDM-Signal-Demultiplexer 2, der die relevanten Daten für den ersten und zweiten Datenstrom d1, d2 aus dem wesentlich umfangreicheren QPSK-Demodulator-Ausgangsstrom dq herausfiltem muß. Der Ausgangsdatenstrom d5 des Reed-Solomon Dekodierers 6, der die eigentliche Information, beispielsweise das BC-Signal, enthält, ist einem Signalprozessor 15 zugeführt, der mit weiteren Schaltungsteilen, beispielsweise den Verstärkern und Wiedergabeeinrichtungen, die in Fig. 1 nicht dargestellt sind, verbunden ist.

Die erste und zweite Zwischenverarbeitungsstufen 7, 8 bzw. 9, 10 können Zeitausgleichstufen oder Puffereinrichtungen 7, 9 für die jeweiligen Datenströme d1, d2 enthalten. Wenn der erste und zweite Datenstrom d1, d2 zusätzlich nach dem Viterbi-Verfahren kodiert sind, dann findet in der ersten und zweiten Zwischenverarbeitungsstufe mittels eines ersten und zweiten Viterbi-Dekodierers 8,10 eine Viterbi-Dekodierung statt, wobei ebenfalls Schaltungen für den Zeitausgleich oder die Pufferung erforderlich sind. Da Viterbi-Dekodierer relativ umfangreiche Schaltungen enthalten und in jedem Datenblock zunächst der zweite Datenstrom d2 zum Gewinnen der nachfolgenden Steuersignale c1, c2 verarbeitet werden muß, ist es für den erforderlichen Schaltungs- und damit Flächenaufwand bei der monolithischen Integration von Vorteil, für beide Datenströme d1, d2 nur einen einzigen Viterbi-Dekodierer 16 zu verwenden. Um den relativ raschen Datenstrom d2 an einen relativ langsamen Viterbi-Dekodierer 10 bzw. 16 anzupassen, ist in Fig. 1 die Puffereinrichtung 9 vorgesehen, die als FIFO-Speicher (= First-In-First-Out) den langsamerern und damit angepaßten Datenstrom d8 bildet.

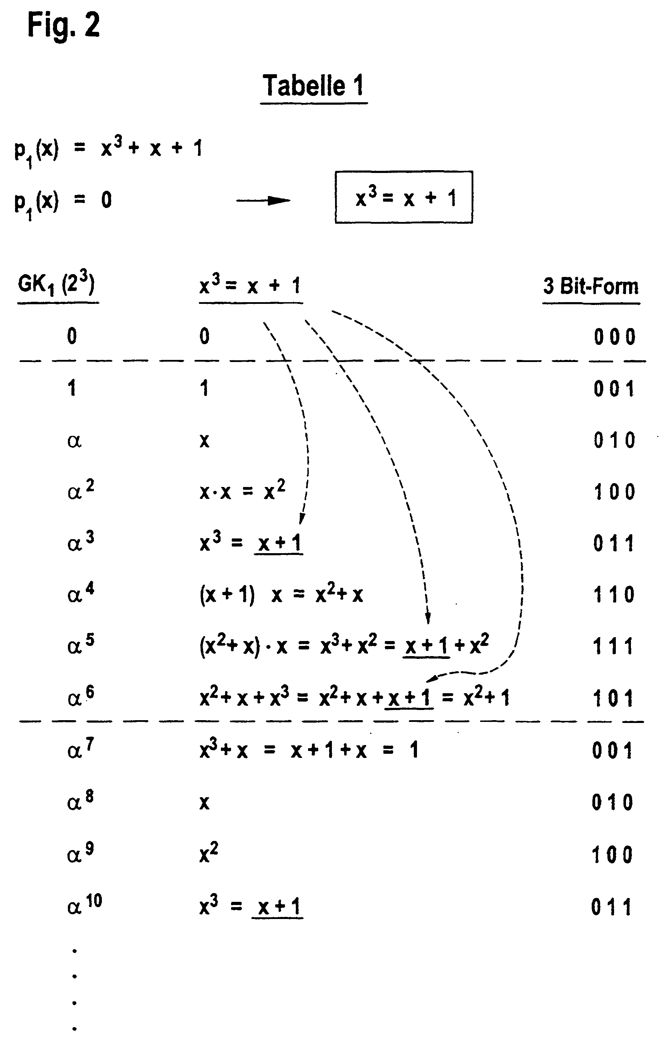

In Fig. 2 ist als Erläuterungsbeispiel in Form einer Tabelle die Herleitung der Elemente eines ersten primitiven Polynoms p₁(x) = x³ + x + 1 dritter Ordnung dargestellt. Die unterschiedlichen Elemente des zugehörige Galois-Körpers dritter Ordnung werden gebildet, indem das erste primitive Polynom p₁(x) = 0 gesetzt wird. Daraus folgt, daß das primitive Element des Galois-Körpers durch die Beziehung x³ = x + 1 definiert ist. Das Einsetzen von "0", "1" oder "αⁱ" in diese Gleichung ergibt die einzelnen Elemente, wobei sich diese wegen der Endlichkeit des Galois-Körpers in gleicher Reihenfolge periodisch wiederholen. Da die einzelnen Elemente der Galois-Körper bei der elektronischen Umsetzung üblicherweise als binäre Daten verarbeitet werden, ist eine binäre Schreibweise für die einzelnen Elemente des jeweiligen Galois-Körpers zweckmäßig, wobei sich die binäre Schreibweise an die einzelnen Wertigkeiten von x des primitiven Polynoms anlehnt. Beim Galois-Körper dritter Ordnung lassen sich somit alle Elemente durch eine dreistellige Binärzahl darstellen. Mit diesen Binärzahlen wird auch im Sinne einer EXOR-Logik gerechnet, beispielsweise im Galois-Parallelmultiplizierer. Für den ganzen Galois-Körper steht in Kurzform daher die Schreibweise GK(2ⁿ), wobei mit "n" die Ordnung gemeint ist. Dies hat auch den Vorteil, daß die Anzahl der unterschiedlichen Elemente sofort erkennbar ist. Bei GK(2³), einem Galois-Körper dritter Ordnung, sind dies ohne das Null-Element "000" sieben unterschiedliche Elemente. Durch die logischen Modulo-Operationen im Reed-Solomon Dekodierer 6 wird dieser Bereich der sieben Elemente nie verlassen.

Die Tabelle Fig. 2 zeigt in der linken Spalte "GK₁(2³)" als aufsteigende Potenzen αⁱ aufeinanderfolgende Elemente des primitiven Polynoms p1(x) = x³ + x + 1. Die mittlere Spalte "x³ = x + 1" zeigt die zugehörigen Bildungsgleichungen, die jedoch auf EXOR-Verknüpfungen beruhen. Die rechte Spalte "3 Bit-Form" zeigt die drei Bit des Galois-Elements, das in diesem Format als Datenwort im Reed-Solomon Dekodierer 6 verarbeitet wird. In der mittleren Spalte sind diejenigen Gleichungsteile der leichteren Verständlichkeit wegen unterstrichen, die sich aus der Nullsetzung des primitiven Polynoms mit p1(x) = 0 ergeben, nämlich x³ = x + 1. Obwohl die einzelnen Elemente von Null aufsteigend entsprechend den Potenzen von α größer werden, zeigt die rechte Spalte mit den binär dargestellten Elementen diese stetig aufsteigende Werte im Sinne der üblichen Zweierpotenzahlen nicht. Abweichungen ergeben sich nach "010", "110", "110", "011" und "110". Das ist aber völlig in Ordnung, denn es handelt sich bei diesem dreistelligen Datenformat nicht um Dualzahlen und ihre zugehörigen Wertigkeiten, sondern lediglich um eine datenförmige Zuordnung zu den einzelnen Elementen. Nach dem letzten Element "101" des Galois-Körpers GK₁(2³) folgt im Sinne der Modulo-Operation als nächstes Element wieder das erste Element "001", wobei das Null-Element "000" ein Sonderelement bildet und immer ausgelassen wird.

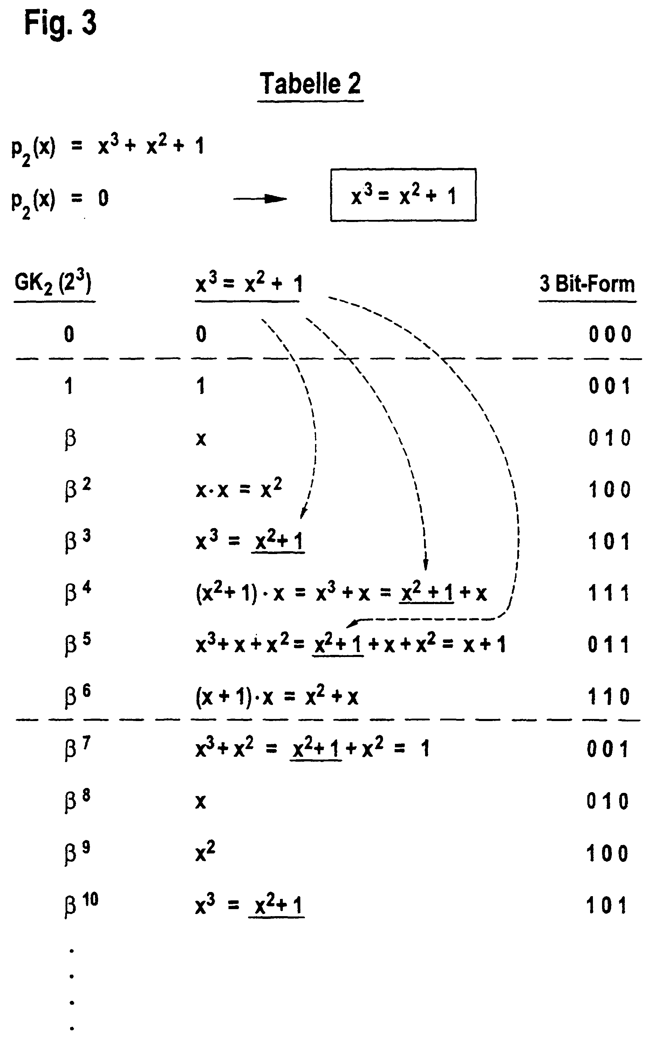

In Fig. 3 sind als "Tabelle 2" die einzelnen Elemente als aufsteigende Potenzen βⁱ eines zweiten Galois-Körpers dritter Ordnung GK₂(2³) dargestellt. Das primitive Polynom p₂(x) zur Bildung dieser Elemente ist p₂(x) = x³ + x² + 1. Der Aufbau der Tabelle 2 mit den drei Spalten "GK₂(2³)", x³ = x² + 1" und "3 Bit Form" entspricht dem Aufbau der Tabelle 1, so daß sich eine nochmalige Beschreibung erübrigt. Jedem der sieben Elemente ist im binären 3 Bit Format ein eigenes Datenwort zugeordnet. Wie in Tabelle 1 entsprechen diese Datenworte jedoch nicht aufsteigenden Dualzahlen. Durch das andere primitive Polynom p₂(x) ist auch die Reihenfolge der Datenworte gegenüber der von Tabelle 1 geändert.

Bei einer isomorphen Abbildung werden die Elemente eines endlichen Körpers in die Elemente eines anderen endlichen Körpers gleicher Ordnung umgesetzt. Dies läßt sich für die nach der Erfindung vorgesehenen Codeumsetzer 11, 12 beispielsweise über eine Tabellenzuordnung durchführen, wenn man die Umsetzung kennt. Die Vorgehensweise, wie man die richtige Umsetzung findet, wird anhand eines einfachen Beispieles erläutert, das die vorhandenen Tabellen 1 und 2 verwendet. Bei der isomorphen Abbildung wird zunächst dasjenige Element αⁱ des einen Galois-Körpers bestimmt, das in das primitive Polynom des anderen Galois-Körpers eingesetzt den Wert Null ergibt und damit definitionsgemäß dort das primitive Element β¹ dieses Galois-Körpers bildet. Potenzen dieses gefundenen primitiven Elementes ergeben dann immer wieder nur Elemente dieses zweiten Galois-Körpers. Diese Erkenntnis gibt einen Weg an, um die einzelnen Zuordnungen für die isomorphe Abbildung eines vorgegebenen Galois-Körpers zu finden. Im erwähnten Beispiel ist das relativ einfach, weil der Galois-Körper nur sieben Elemente aufweist, die leicht in das primitive Polynom des anderen Galois-Körpers eingesetzt werden können. Wenn die Anzahl der Elemente groß ist, also beispielsweise bei einem Galois-Körper siebter Ordnung, dann ist dieses Einsetzen von Hand nicht mehr möglich. Mittels eines geeigneten Programms kann dieses sukzessive Durchmustern auf einfache Weise automatisch über einen Rechner erfolgen. Wenn bei diesem Durchmustern mehrere Elemente gefunden werden, die in das primitive Polynom eingesetzt den Wert Null ergeben, dann kann jeder dieser Lösungen als ein primitives Element für eine zugehörige isomorphe Abbildung dienen. Allerdings sind nicht alle Lösungen im Hinblick auf den jeweiligen Anwendungsfall gleichwertig. Die optimale Lösung kann über eine Simulation der Reed-Solomon Dekodierung herausgefunden werden.

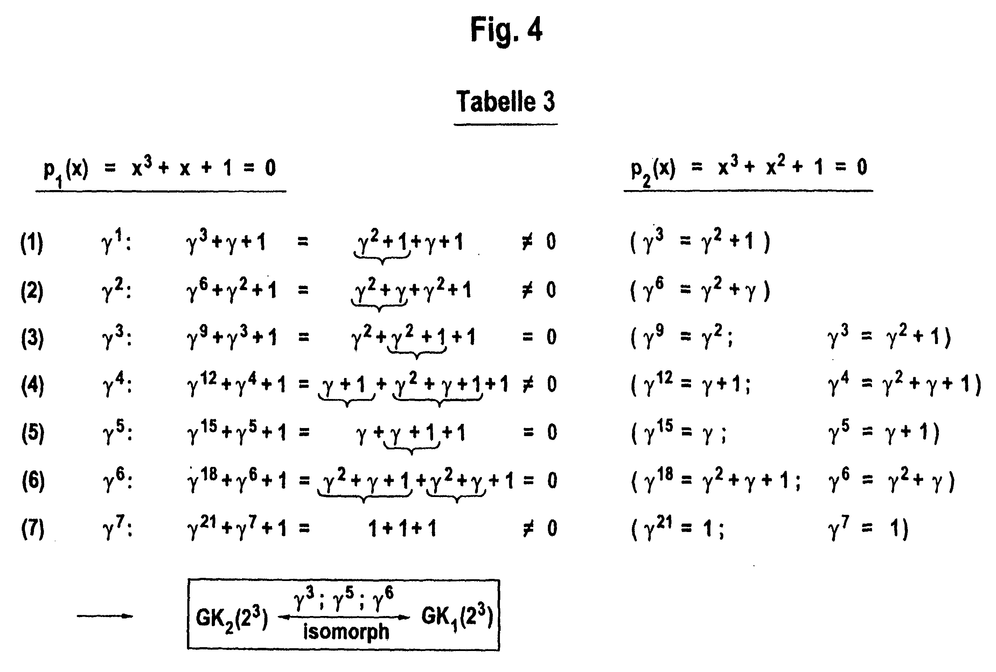

In Fig. 4 ist als Tabelle 3 ein Beispiel für dieses sukzessive Einsetzen der sieben Elemente γ¹ bis γ⁷ des zweiten primitiven Polynoms p₂(x) = x³ + x² + 1 in das erste primitve Polynom p₁(x) = x³ + x + 1 dargestellt, um herauszufinden, für welche Elemente das erste primitive Polynom zu Null wird. Die zu prüfenden Elemente γ sind dabei nach steigenden Potenzen γⁱ zeilenweise geordnet. Die dritte, fünfte und sechste Zeile mit den primitiven Elementen γ³ bzw. γ⁵ bzw. γ⁶ ergibt beim Einsetzen in das erste primitive Polynom p₁(x) = x³ + x + 1 jeweils den Wert Null. Somit stellen diese Elemente γ³, γ⁵ und γ⁶ jeweils ein primitives Element dar. Es wird auch hier darauf hingewiesen, daß es sich bei der Berechnung des ersten primitiven Polynoms p₁(x) bei den Vielfachen und Potenzen von γ um Multiplikationen und bei dem "+"-Zeichen um XOR-Verknüpfungen handelt.

Um die Zuordnung zwischen den Elementen des zweiten primitiven Polynoms und des ersten primitiven Polnoms und damit die Abbildung von GK2 nach GK1 und dazu die rückwärtige Abbildung von GK1 nach GK2 zu erhalten, sind entsprechend den erhaltenen Lösungen γ³ bzw. γ⁵ bzw. γ⁶ zunächst die zugehörigen Restklassen zu bilden. Mit der Funktion Restklasse wird die Modulo-Division des angegebenen primitiven Polynoms bezeichnet, wobei der Rest aus dieser Division das Ergebnis ist. Entsprechend dem Exponent i der jeweiligen Lösung γ, ist für jede Modulo-Division der zugehörige Exponent des Elements zu multiplizieren. Im vorliegenden Beispiel mit γ³ ist der Exponent des gefundenen Lösungwertes 3. Da GK(2³), also ein GK dritter Ordnung über sieben unterschiedliche primitve Elemente verfügt, ist der Wert 7 für die Modulo-Division maßgebend. Die Schreibweise für diese Modulo-Division ist unterschiedlich, "mod (x, y)" oder "x mod y", das bedeutet beispielsweise mit x=18 und y=7 die Division 18/7 = 2 + 4/7. Bei diesem Divisonsbeispiel ist 4 der nicht mehr durch 7 teilbare Rest und damit die Lösung der Modulo-Division. In der oben angegebenen Schreibweise sieht das dann wie folgt aus: 18 mod 7 = 4.

Die sieben Elemente des gesuchten GK(2³), die bis jetzt noch nicht gefunden sind, sind formal in folgender Tabelle T(GK(2³)) aufgelistet. Dabei steigen die Exponenten i der Potenzen δⁱ von i=0 bis i=6 an. Die Exponenten i=7 und i=0 liefern wegen der endlichen Anzahl - es sind wie bereits angegeben sieben unterschiedliche Elemente - der Elemente im Galois-Körper dritter Ordnung das selbe Element δ⁰. Mit "δ" wird das primitive Element eines beliebigen Galois-Körpers dritter Ordnung bezeichnet. Die zugehörigen Elemente δⁱ ergeben sich dann mit aufsteigendem i von i=0 bis i=6 als Tabelle T(δⁱ):
- T(δⁱ) :: {δ⁰, δ¹, δ², δ³, δ⁴, δ⁵, δ⁶}
In vereinfachter Schreibform, bei der nur die Exponenten i der Tabelle T(δⁱ) verwendet werden, lassen sich die aufeinanderfolgenden sieben Elemente eines beliebigen Galois-Körpers dritter Ordnung verallgemeinert wie folgt in Tabellenform darstellen:
- T(GK(2³)):: {0, 1, 2, 3, 4, 5, 6}
Aus dieser Tabelle werden nun über die Restklassenbildung mit den gefundenen Lösungen von γ³ ,γ⁵ und γ⁶ die Transformationen durchgeführt.

Ein ausführliches Beispiel zeigt die Transformation aller Feldelemente (i) der oben angegebenen Tabelle T(GK(2³)): {0, 1, 2, 3, 4, 5, 6} für die Lösung γ³:

| | | |
|---|---|---|
| i = 0: mod(0·3,7) = mod (0,7) = 0 | im 3-Bit Format (vgl. Tabelle 2): | 001 |
| i = 1: mod(1·3,7) = mod (3,7) = 3 | dito | 011 |
| i = 2: mod(2·3,7) = mod (6,7) = 6 | dito | 101 |
| i = 3: mod(3·3,7) = mod (9, 7) = 2 | dito | 100 |
| i = 4: mod(4·3,7) = mod (12,7) = 5 | dito | 111 |
| i = 5: mod(5·3,7) = mod (15,7) = 1 | dito | 010 |
| i = 6: mod(6. 3, 7) = mod (18, 7) = 4 | dito | 110 |
| i = 7: mod(7·3,7) = mod (21,7) = 0 | (denn 7 mod 7 = 0) dito | 001 |
| i = 8: mod(8·3,7) = mod (24,7) = 3 | dito | 011 |
| i = 9: mod(9·3,7) = mod (27,7) = 6 | dito | 101 |

Ab i=7 wiederholen sich die Feld-Elemente. Die zu der γ³ gehörige Tabelle der Feld-Elemente, also die zugehörige Transformations-Tabelle, ist T1(γ³): {0, 3, 6, 2, 5, 1, 4}.

Für die drei Lösungen γ³, γ⁵ und γ⁶ gibt es damit folgende drei Transformations-Tabellen, die durch die oben beschriebene Modulo-Division auf gleiche Weise gebildet werden:
- T1(γ³):: {0,3,6,2,5,1,4}
- T2(γ⁵):: {0,5,3,1,6,4,2}
- T3(γ⁶):: {0, 6, 5, 4, 3, 2, 1}

Die Rücktransformation der Tabelle T1(γ³): {0,.3, 6, 2, 5, 1, 4} mit γ³, γ⁵ und γ⁶ über die Modulo-Division ergibt die drei folgenden Rücktransformations-Tabellen:
- T4(γ³):: {0, 2, 4, 6, 1, 3, 5}
- T5(γ⁵):: {0, 1, 2, 3, 4, 5, 6}
- T6(γ⁶):: {0, 4, 1, 5, 2, 6, 3}
Nur die Rücktransformations-Tabelle T5(γ⁵): {0, 1, 2, 3, 4, 5, 6}, die mit γ⁵ rücktransformiert wurde, zeigt wieder die ursprünglichen Feld-Elemente T(GK(2³)): {0, 1, 2, 3, 4, 5, 6}. Für die Transformation in der einen Richtung gilt die Abbildungsvorschrift γ³ und für die Rücktransformation die Abbildungsvorschrift γ⁵. Es ist dabei unerheblich, in welcher Richtung zwischen dem ersten und zweiten Galois-Körper die Hin- und Rücktransformation erfolgt. Also wenn die Hintransformation von GK₁(2³) nach GK₂(2³) bzw. von GK₂(2³) nach GK₁(2³) nach der Abbildungssvorschrift γ³ erfolgt, dann muß die Rücktransformation von GK₂(2³) nach GK₁(2³) bzw. von GK₁(2³) nach GK₂(2³) nach der Abbildungsvorschrift γ⁵ erfolgen.

Auf ähnliche Weise kann dargestellt werden, daß die Rücktransformation der zweiten Transformations-Tabelle T2(γ⁵): {0, 5, 3, 1, 6, 4, 2} mit γ³, γ⁵ und γ⁶ als Feld-Elemente folgende Rücktransformations-Tabellen ergibt:
- T7(γ³):: {0, 1, 2, 3, 4, 5, 6}
- T8(γ⁵):: {0, 4, 1, 5, 2, 6, 3}
- T9(γ⁶):: {0, 2, 4, 6, 1, 3, 5}

Nur die Rücktransformations-Tabelle T7(γ³): {0, 1, 2, 3, 4, 5, 6}, die mit γ³ rücktransformiert wurde, zeigt wieder die ursprünglichen Feld-Elemente T(GK(2³)): {0, 1, 2, 3, 4, 5, 6}. Die Hintransformation erfolgt über die Abbildungsvorschrift γ⁵ und die Rücktransformation über die Abbildungsvorschrift γ³.

Die Rücktransformation der dritten Transformations-Tabelle T3(γ⁶): {0, 6, 5, 4, 3, 2, 1} mit γ³, γ⁵ und γ⁶ ergibt als Feld-Elemente folgende Rücktransformations-Tabellen:
- T10(γ³):: {0, 4, 1, 5, 2, 6, 3}
- T11(γ⁶):: {0, 2, 4, 6, 1, 3, 5}
- T12(γ⁶):: {0, 1, 2, 3, 4, 5, 6}

Nur die Rücktransformations-Tabelle T12(γ⁶): {0, 1, 2, 3, 4, 5, 6}, die mit γ⁶ rücktransformiert wurde, zeigt wieder die ursprünglichen Feld-Elemente T(GK(2³)): {0, 1, 2, 3, 4, 5, 6}. In diesem Transformationsfall erfolgt die Hin- und Rücktransformation mit der gleichen Abbildungsvorschrift γ⁶.

Die Hin- und Rücktransformation der einzelnen Elemente läßt sich vereinfacht über eine Restklassentabelle Tr darstellen. Mit der Abbildungsvorschrift γ⁵ für die Hintransformation und den drei Feldelementen i = 0, 1, 2, wegen der dritten Ordnung der beiden Galois-Körper GK₁(2³) und GK₂(2³), ergibt sich folgende Restklassentabelle Tr1: Tr1: {1, 1+x+x²,1+x} in Polynomform
Tr1: { 001 111 011 } im 3-Bit Format.
Eine andere Schreibweise für das 3-Bit Format von Tr1 ist eine 3 x 3 Matrix:

| | | |
|---|---|---|
| 0 | 0 | 1 |
| 1 | 1 | 1 |
| 0 | 1 | 1 |

Die Rücktransformation ergibt auf ähnliche Weise mit der Abbildungsvorschrift γ³ und den drei Feldelementen i = 0, 1, 2 die Restklassentabelle Tr2:
- Tr2:: {1, 1+x+x², 1+x} in Polynomform
- Tr2:: {001 101 110 }im 3-Bit Format.

Eine andere Schreibweise für das 3-Bit Format von Tr2 ist eine 3 x 3 Matrix:

| | | |
|---|---|---|
| 0 | 0 | 1 |
| 1 | 0 | 1 |
| 1 | 1 | 0 |

Das sind gegenüber den 42- Bit der direkten Tabellendarstellung für die 7 primitven Elemente mit je 3 Bit und den zugehörigen 7 Adressen mit ebenfalls je 3 Bit nur noch 9 Bit, die für eine Transformation zu speichern sind. Diese Matrixdarstellung für die isomorphe Abbildung am Beispiel eines ersten und zweiten Galois-Körpers dritter Ordnung zeigt, daß die Abbildung auf diese Weise besonders einfach in einem GK-Prozessor realisierbar ist und dort wenig Speicher- und Rechenaufwand erfordert. Bei Galois-Körpem höherer Ordnung ist der Einsparungseffekt durch die Matrixdarstellung noch größer.

## Patentansprüche

1. Einrichtung (1) für einen Reed-Solomon Dekodierer (6), die von einer Datenquelle (2) im Zeitmultiplexbetrieb mindestens mit einem ersten und zweiten Datenstrom (d1, d2) gespeist ist, deren Daten jeweils einem ersten bzw. zweiten Reed-Solomon-Code entsprechen, wobei ein zugehöriges erstes und zweites primitives Polynom zueinander unterschiedlich, jedoch von gleicher Ordnung sind,
- mit einem ersten Betriebsmodus,
- in dem der erste Datenstrom (d1) einem Dateneingang des Reed-Solomon-Dekodierers (6), dessen Dekodierungsverfahren durch das erste primitive Polynom und mindestens ein erstes Generatorpolynom definiert ist,
- direkt oder
- über eine erste Zwischenverarbeitungsstufe (7, 8) zugeführt wird,
- mit einem zweiten Betriebsmodus,
- in dem der zweite Datenstrom (d2) einem ersten Codeumsetzer (11)
- direkt oder
- über eine zweite Zwischenverarbeitungsstufe (9,10) zugeführt wird,
- wobei der erste Codeumsetzer (11) eine isomorphe Abbildung der dem zweiten primitiven Polynom zugeordneten Daten in dem ersten primitiven Polynom zugeordnete Daten durchführt, und
- der Ausgang des ersten Codeumsetzers (11) den Dateneingang des Reed-Solomon-Dekodierers (6) speist,
- ein Datenausgang des Reed-Solomon-Dekodierers (6) im ersten bzw. zweiten Betriebsmodus einen fünften (d5) bzw. einen sechsten Datenstrom (d6) liefert, und
- der sechste Datenstrom (d6) mittels eines zweiten Codeumsetzers (12),
- der eine zum ersten Codeumsetzer (11) inverse isomorphe Abbildung der dem ersten primitiven Polynom zugeordneten Daten in dem zweiten primitiven Polynom zugeordnete Daten durchführt,
in einen siebten Datenstrom (d7) umgesetzt wird.

2. Einrichtung (1) nach Anspruch 1, **dadurch gekennzeichnet, daß** die erste und zweite Zwischenverarbeitungsstufe (7, 8; 9, 10) einen ersten bzw. zweiten Viterbi-Dekodierer (8, 10) enthält.

3. Einrichtung (1) nach Anspruch 2, **gekennzeichnet durch** folgende Merkmale:
- für die erste und zweite Zwischenverarbeitungsstufe (7, 8: 8, 10) ist ein einziger Viterbi-Dekodierer (16) vorhanden,
- im ersten Betriebsmodus ist der einzige Viterbi-Dekodierer (16) mit dem ersten Datenstrom (d1) oder einem von ihm abhängigen zehnten Datenstrom (d10) gespeist und sein Ausgang ist direkt mit dem Eingang des Reed-Solomon Dekodierers (6) verbunden und
- im zweiten Betriebsmodus ist der einzige Viterbi-Dekodierer (16) mit einem vom zweiten Datenstrom (d2) abhängigen achten Datenstrom (d8) gespeist und sein Ausgang ist über den ersten Codeumsetzer (11) mit dem Eingang des Reed-Solomon Dekodierers (6) verbunden.

4. Einrichtung (1) nach Anspruch 2 oder 3, **dadurch gekennzeichnet, daß** in der zweiten Zwischenverarbeitungsstufe (9, 10) vor dem ersten Viterbi-Dekodierer (8) oder dem einzigen Viterbi-Dekodierer (16) eine Puffereinrichtung (9) für den zweiten Datenstrom (d2) vorhanden ist, die den achten Datenstrom (d8) liefert.

5. Einrichtung (1) nach einem der Ansprüche 1 bis 4, **dadurch gekennzeichnet, daß** zur Datenumsetzung im ersten und zweiten Codeumsetzer (11, 12) jeweils eine gespeicherte Tabelle oder ein Unterprogramm oder eine Kombination aus einer gepeicherter Tabelle und einem Unterprogramm vorhanden ist.

6. Einrichtung (1) nach einem der Ansprüche 1 bis 5, **dadurch gekennzeichnet, daß** die Daten des siebten Datenstromes (d7), die über eine Steuereinrichtung (14) der Steuerung des ersten und zweiten Betriebsmodus dienen, in der Einrichtung (1) mittels eines statischen Speichers (13) gespeichert sind.

7. Einrichtung (1) nach einem der Ansprüche 1 bis 5, **dadurch gekennzeichnet, daß** die Daten des fünften Datenstromes (d5) zur weiteren Verarbeitung einem Signalprozessor (15) zugeführt sind.

## Claims

1. A device (1) for a Reed-Solomon Decoder (6) which is fed from a data source (2) in a time-division multiplex mode with a first data stream (d1) and a second data stream (d2) whose data correspond to a first Reed-Solomon code and a second Reed-Solomon code, respectively, an associated first primitive polynomial and an associated second primitive polynomial being different from one another but of the same order,
- with a first operating mode
- in which the first data stream (d1) is applied
- directly or
- through a first intermediate processing stage (7, 8)
to a data input of the Reed-Solomon decoder (6), whose decoding technique is defined by the first primitive polynomial and at least a first generator polynomial,
- with a second operating mode
- in which the second data stream (d2) is applied
- directly or
- through a second intermediate processing stage (9, 10)
to a first code converter (11),
- with the first code converter (11) performing an isomorphic mapping of the data associated with the second primitive polynomial into data associated with the first primitive polynomial, and
- the output of the first code converter (11) feeding the data input of the Reed-Solomon decoder (6),
- wherein a data output of the Reed-Solomon decoder (6) provides a fifth data stream (d5) in the first operating mode and a sixth data stream (d6) in the second operating mode, and
- wherein the sixth data stream (d6) is converted to a seventh data stream (d7) by means of a second code converter (12)
- which performs an isomorphic mapping of the data associated with the first primitive polynomial into data associated with the second primitive polynomial which is inverse to the isomorphic mapping performed by the first code converter (11).

2. A device (1) as claimed in claim 1, **characterized in that** the first and second intermediate processing stages (7, 8; 9, 10) comprise a first Viterbi decoder (8) and a second Viterbi decoder (10), respectively.

3. A device (1) as claimed in claim 2, **characterized by** the following features:
- for the first and second intermediate processing stages (7, 8; 9, 10), a single Viterbi decoder (16) is provided;
- in the first operating mode, the single Viterbi decoder (16) is fed by the first data stream (d1) or by a tenth data stream (d10) dependent on the first data stream (d1), and its output is connected directly to the input of the Reed-Solomon decoder (6); and
- in the second operating mode, the single Viterbi decoder (16) is fed by an eighth data stream (d8) dependent on the second data stream (d2), and its output is connected to the input of the Reed-Solomon decoder (6) via the first code converter (11).

4. A device (1) as claimed in claim 2 or 3, **characterized in that** in the second intermediate processing stage (9, 10), the second Viterbi decoder (10) or the single Viterbi decoder (16) is preceded by a buffer device (9) for the second data stream (d2) which provides the eighth data stream (d8).

5. A device (1) as claimed in any one of claims 1 to 4, **characterized in that** for data conversion, the first and second code converters (11, 12) each contain a stored table for a subprogram or a combination of a stored table and a subprogram.

6. A device (1) as claimed in any one of claims 1 to 5, **characterized in that** the data of the seventh data stream (d7), which serve to control the first and second operating modes via a controller (14), are stored in the device (1) by means of a static memory (13).

7. A device (1) as claimed in any one of claims 1 to 5, **characterized in that** the data of the fifth data stream (d5) are fed to a signal processor (15) for further processing.

## Revendications

1. Dispositif (1) pour un décodeur de Reed-Solomon (6) qui est alimenté en fonctionnement en multiplex à répartition dans le temps au moins par un premier et un deuxième flux de données (d1, d2) qui proviennent d'une source de données (2) et dont les données correspondent, à chaque fois, à un premier, respectivement deuxième, code de Reed-Solomon, un premier associé et un deuxième polynôme primitif étant différents l'un de l'autre, mais du même ordre, ledit dispositif ayant :
un premier mode de fonctionnement,
- dans lequel le premier flux de données (d1) est envoyé
. directement ou
. par l'intermédiaire d'un premier étage intermédiaire de traitement (7, 8),
à une entrée de données du décodeur de Reed-Solomon (6) dont le processus de décodage est défini par le premier polynôme primitif et au moins un premier polynôme de générateur,
et un deuxième mode de fonctionnement,
- dans lequel le deuxième flux de données (d2) est envoyé
- directement ou
- par l'intermédiaire d'un deuxième étage intermédiaire de traitement (9, 10),
à un premier transcodeur (11)
- le premier transcodeur (11) réalisant une application isomorphe des données associées au deuxième polynôme primitif dans les données associées au premier polynôme primitif et
- la sortie du premier transcodeur (11) alimentant l'entrée de données du décodeur de Reed-Solomon (6)
- une sortie de données du décodeur de Reed-Solomon (6) délivrant, dans un premier, respectivement deuxième mode de fonctionnement, un cinquième (d5), respectivement un sixième (d6) flux de données et
- le sixième flux de données (d6) étant transformé en un septième flux de données (d7) au moyen d'un deuxième transcodeur (12),
- qui réalise une application isomorphe inverse à celle du premier transcodeur (11) des données associées au premier polynôme primitif dans les données associées au deuxième polynôme primitif.

2. Dispositif selon la revendication 1, **caractérisé en ce que** les premier et deuxième étages intermédiaires de traitement (7, 8 ; 9, 10) comprennent un premier, respectivement un deuxième, décodeurs de Viterbi (8, 10).

3. Dispositif selon la revendication 2, **caractérisé par** les caractéristiques suivantes :
- pour le premier et le deuxième étage intermédiaire de traitement (7, 8 ; 9, 10), on prévoit un décodeur de Viterbi unique (16),
- dans le premier mode de fonctionnement, le décodeur de Viterbi unique (16) est alimenté par le premier flux de données (d1) ou par un dixième flux de données (d10) indépendant de ce dernier et sa sortie est reliée directement à l'entrée du décodeur de Reed-Solomon (6) et
- dans le deuxième mode de fonctionnement, le décodeur de Viterbi unique (16) est alimenté par un huitième flux de données (d8) qui est dépendant du deuxième flux de données (d2) et sa sortie est reliée, par l'intermédiaire du premier transcodeur (11), à l'entrée du décodeur de Reed-Solomon (6).

4. Dispositif selon la revendication 2 ou 3, **caractérisé en ce que**, dans le deuxième étage intermédiaire de traitement (9, 10), on prévoit, avant le premier décodeur de Viterbi (8) ou avant le décodeur de Viterbi unique (16), un dispositif tampon (9) qui est prévu pour le deuxième flux de données (d2) et qui fournit le huitième flux de données (d8).

5. Dispositif selon l'une quelconque des revendications 1 à 4, **caractérisé en ce que**, pour la transformation des données dans le premier et le deuxième transcodeurs (11, 12), on prévoit, à chaque fois, un tableau mémorisé ou un sous-programme ou une combinaison d'un tableau mémorisé et d'un sous-programme.

6. Dispositif selon l'une quelconque des revendications 1 à 5, **caractérisé en ce que** les données du septième flux de données (d7) qui servent, par l'intermédiaire d'un dispositif de commande (14), à la commande des premier et deuxième modes de fonctionnement sont mémorisées dans le dispositif (1) au moyen d'une mémoire statique (13).

7. Dispositif selon l'une quelconque des revendications 1 à 5, **caractérisé en ce que** les données du cinquième flux de données (d4) sont envoyées, pour un nouveau traitement, à un processeur de signaux.
